# DEMANDE DE BREVET EUROPEEN

(11) **EP 3 451 458 A1**
(43) Date de publication de la demande: **06.03.2019**
(21) Numéro de dépôt: 18188626.8
(22) Date de dépôt: 13.08.2018
(51) Int. Cl.: H01R 13/00, B60L 50/64, H01M 2/20, H01R 11/28, H01M 10/6553, H01M 10/6556

(54) **DISPOSITIF DE CONNEXION ÉLECTRIQUE ET REFROIDISSEMENT DE CELUI CI**

(30) Priorité: 29.08.2017 FR 1757940
(71) Demandeur: Aptiv Technologies Limited, St. Michael (BB)
(72) Inventeur: MENEZ, Frédéric, 78125 HERMERAY (FR); FABRE, Jean, 28000 CHARTRES (FR); LACOTE, Stéphane, 28000 CHARTRES (FR)
(74) Mandataire: Robert, Vincent

(57) **Abrégé**

Un shunt de connexion électrique (16), prévu pour être couplé électriquement entre deux bornes électriques de contact (122, 124), comprend un ensemble d'éléments de conductions de courant électrique, le dit ensemble d'éléments de conduction comprenant un premier terminal électrique de connexion (26) et un second terminal électrique de connexion (28) prévus pour être accouplés avec une première et une seconde borne électrique de contact (122, 124) et prévus pour faire circuler un courant électrique entre chaque borne électrique de contact (122, 124) et le terminal électrique de connexion (26, 28) accouplé à la borne électrique de contact (122, 124), un élément électrique de raccordement (30) des deux terminaux électriques de connexion (26, 28) prévu pour faire circuler le courant électrique d'un terminal électrique de connexion (26) vers l'autre terminal électrique de connexion (28) ; au moins un des éléments de conduction (26) comportant un conduit de shunt (42) agencé au travers de l'élément de conduction (26) de sorte à y faire circuler un fluide de refroidissement.

## Description

### DOMAINE TECHNIQUE

La présente invention concerne un dispositif de connexion électrique et son circuit de refroidissement, plus particulièrement la présente invention concerne un shunt de connexion électrique et ses bornes électriques de contact comprenant un circuit de refroidissement.

### ARRIERE-PLAN TECHNOLOGIQUE DE L'INVENTION

Pour les véhicules automobiles hybrides ou électriques, il est connu d'utiliser un pack batterie haute tension afin d'alimenter les divers organes de la machine électrique de tels véhicules. Généralement, les pack batteries comportent une pluralité d'élément de batterie de tension plus modéré interconnecté entre eux afin d'obtenir la haute tension désirée.

Il est connu d'utiliser des shunts de connexion électrique pour réaliser l'interconnexion entre les éléments de batterie. Cependant, avec l'augmentation constante des besoins en courants de ce type de véhicules, et afin d'éviter une surchauffe des shunts de connexion, la taille des shunts à tendance à s'accroitre de sorte que l'encombrement du pack batterie devient un vrai problème pour son implémentation dans les véhicules.

Il est donc important de proposer une solution nouvelle résolvant ces problèmes.

### RESUME DE L'INVENTION

Un shunt de connexion électrique, prévu pour être couplé électriquement entre deux bornes électriques de contact, comporte un ensemble d'éléments de conductions de courant électrique, le dit ensemble d'éléments de conduction comprenant un premier terminal électrique de connexion et un second terminal électrique de connexion, s'étendant selon un axe vertical, et prévus pour être accouplés avec une première et une seconde borne électrique de contact et prévus pour faire circuler un courant électrique entre chaque borne électrique de contact et le terminal électrique de connexion accouplé à la borne électrique de contact. Un élément électrique de raccordement des deux terminaux électriques de connexion est prévu pour faire circuler le courant électrique d'un terminal électrique de connexion vers l'autre terminal électrique de connexion. Au moins un des éléments de conduction comporte un conduit de shunt agencé au travers de l'élément de conduction de sorte à y faire circuler un fluide de refroidissement. Le fluide de refroidissement permet de réduire l'échauffement des éléments de conduction du shunt, et permet de garder une taille raisonnable de shunt.

Le conduit de shunt peut être un conduit débouchant dont au moins une extrémité comprend un moyen d'interconnexion de shunt prévu pour y raccorder un tuyau de refroidissement. Le tuyau de refroidissement permet de canaliser le trajet d'un fluide de refroidissement tel que de l'air ou un élément aqueux. Le conduit de shunt peut être un conduit rectiligne.

Le premier terminal électrique de connexion peut être un terminal électrique mâle de connexion comprenant une extrémité de contact globalement cylindrique prévue pour être inséré dans la première borne électrique de contact. Le conduit de shunt peut être agencé au travers du premier terminal électrique de connexion et peut s'étendre selon l'axe vertical. L'extrémité de contact du premier terminal électrique peut comprendre une cavité interne agencée en continuité de fluide avec le conduit de shunt de sorte à pouvoir y insérer un autre conduit faisant circuler le fluide de refroidissement en continuité avec le conduit de shunt. Le second terminal électrique de connexion peut comporter les mêmes caractéristiques que le premier terminal électrique de connexion.

Une borne électrique de contact prévue pour recevoir un terminal électrique de connexion d'un shunt de connexion électrique comprend un terminal électrique de raccord prévu pour être accouplé électriquement avec ledit terminal électrique de connexion du shunt. Un conduit de borne est agencé au travers de la borne de contact de sorte à y faire circuler un fluide de refroidissement. Le fluide de refroidissement permet de réduire l'échauffement de la borne de contact, et permet de garder une taille raisonnable de la borne de contact.

Le conduit de borne peut être un conduit débouchant dont au moins une extrémité du conduit comprend un moyen d'interconnexion de borne prévu pour y raccorder un autre tuyau de refroidissement. Le tuyau de refroidissement permet de canaliser le trajet du fluide de refroidissement tel que de l'air ou un élément aqueux. Le conduit de borne peut être un conduit rectiligne. Le terminal électrique de raccord peut être un terminal électrique femelle s'étendant selon un axe vertical et comprenant un manchon de contact globalement cylindrique s'étendant selon l'axe vertical et prévu pour recevoir le terminal électrique de connexion du shunt.

Un boîtier peut recouvrir la paroi cylindrique du manchon de contact, le boîtier comprenant un fond de boîtier au travers duquel est agencé le conduit de borne s'étendant selon l'axe vertical. Un pion creux peut être agencé sur le fond de boîtier, le pion creux s'étendant selon l'axe vertical depuis le fond de boîtier jusqu'à l'intérieur du manchon de contact de sorte à pouvoir venir s'insérer dans une cavité interne de l'extrémité de contact du terminal électrique de connexion mâle du shunt, et formant le conduit de borne de sorte à permettre la circulation du fluide de refroidissement.

Le pion peut comporter un joint agencé autour du pion, le joint étant prévu pour être comprimé de façon étanche entre la cavité interne et le pion. Le fond de boîtier peut comprendre une cheminée d'extraction du fluide de refroidissement formant le conduit de borne et s'étendant vers le bas selon l'axe vertical.

Un assemblage électrique comprenant le shunt de connexion électrique et la borne électrique de contact, tous deux décrits ce dessus, comprend le premier terminal électrique de connexion du shunt accouplé électriquement avec le terminal de raccord de la première borne électrique de contact.

Le conduit de shunt peut être en continuité de fluide avec le conduit de borne. L'assemblage peut comprendre un premier tuyau de refroidissement fixé en continuité de fluide avec le conduit de shunt et un second tuyau de refroidissement fixé en continuité de fluide avec le conduit de borne. Au moins un des tuyaux de refroidissement peut être fixé à une de ses extrémités à une pompe permettant la circulation du fluide de refroidissement.

L'assemblage du second terminal électrique de connexion du shunt avec le terminal électrique de raccord de la seconde borne électrique de contact peut comporter les mêmes caractéristiques que l'assemblage du premier terminal électrique de connexion du shunt avec le terminal électrique de raccord de la première borne électrique de contact.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est vue schématique en perspective d'un pack batterie comportant des éléments de batterie connectés électriquement entre eux par un shunt de connexion électrique selon premier mode de réalisation de l'invention.
- La figure 2 est une vue schématique en perspective d'un premier mode de réalisation d'un shunt de connexion électrique prévue pour connecter électriquement les éléments de batterie de la figure 1.
- La figure 3 est une vue schématique en perspective du shunt selon la figure 2 sans son élément de boîtier plastique.
- La figure 4 est une schématique en coupe axiale du shunt selon la figure 2.
- La figure 5 est une vue schématique éclatée en perspective d'un premier mode de réalisation d'une borne électrique de contact prévue pour recevoir un terminal électrique de connexion du shunt selon la figure 2.
- La figure 6 est une vue schématique en coupe axial de la borne électrique de contact assemblée selon la figure 5 et montée sur un élément de batterie.
- La figure 7 est une vue schématique en coupe axial d'un mode de réalisation de l'assemblage électrique du shunt de connexion électrique selon la figure 2 avec deux bornes électrique de contact selon la figure 5.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

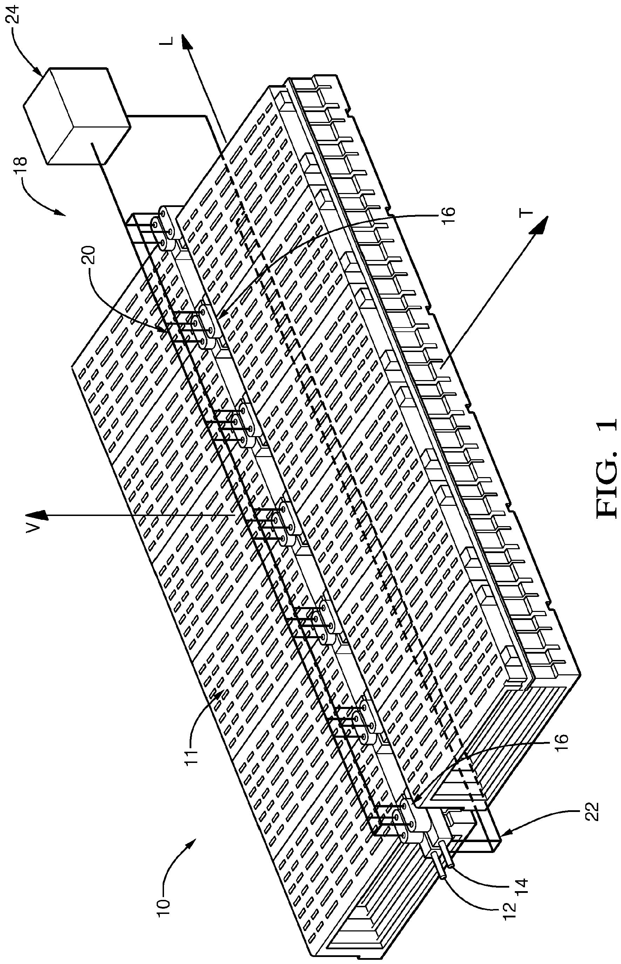

Selon la figure 1, un assemblage 10 d'éléments de batterie 11 prévu pour être embarqué dans un véhicule hybride ou dans un véhicule électrique est représenté. A des fins de limitation d'encombrement, les éléments de batterie 11 sont disposés en deux rangés adjacentes longitudinales. L'assemblage 10 des éléments de batterie 11 comporte à une de ses deux extrémités transversales un plot de contact positif 12 et un plot de contact négatif 14 entre lesquels est délivrée la tension globale de l'assemblage 10 des éléments batterie 11.

Selon le mode de réalisation représenté, l'assemblage 10 des éléments de batteries 11 comprend douze éléments de batteries 11, chaque rangée comportant six éléments de batterie 11. Les éléments de batteries 11 sont montés en série, cela signifie que le pôle positif du premier élément de batterie est connecté au pôle négatif du second élément de batterie, le pôle positif du second élément de batterie est connecté au pôle négatif du troisième élément de batterie, et ainsi de suite, jusqu'au douzième élément de batterie pour lequel le pôle positif est relié électriquement au plot de contact positif 12 de l'assemblage 10 d'éléments de batterie 11. Le pôle négatif du premier élément de batterie est relié électriquement au plot de contact négatif 14 de l'assemblage 10 d'éléments de batterie 11.

Selon le mode de réalisation représenté, la connexion électrique entre les pôles positifs et les pôles négatifs des éléments de batterie 11 est réalisée à l'aide de shunts 16 de connexion électrique. De façon particulière les shunts 16 sont agencés entre les deux rangés d'éléments de batterie 11. Cet arrangement permet notamment d'agencer à l'extrémité opposée aux plots de contact positif 12 et négatif 14, un shunt connecté entre le pôle positif du sixième élément de batterie et une borne d'un fusible de protection de l'assemblage 10 d'éléments de batterie 11, et également un autre shunt connecté entre le pôle négatif du septième élément de batterie et l'autre borne du fusible.

Egalement, selon ce mode de réalisation, chaque plot de contact 12, 14 est relié électriquement à son élément de batterie par un shunt de connexion électrique 16.

Lors de la sollicitation de l'assemblage 10 d'éléments de batterie 11, un courant électrique très important, par exemple de l'ordre de quatre cent ampères, peut être amené à circuler au travers de chaque shunt 16 de connexion électrique. Le courant électrique circulant dans chaque shunt 16 crée un échauffement de ceux-ci. Une des façons de réduire l'échauffement des shunts 16 électriques de connexion est de les refroidir.

Selon le mode de réalisation représenté, un circuit de refroidissement 18 des shunts 16 est implémenté. Le circuit de refroidissement 18 comprend des tuyaux de refroidissement 20, 22 permettant de faire circuler un fluide de refroidissement, comme de l'air, un gaz, de l'eau ou tout autre liquide, à travers les shunts 16. Plus particulièrement, on identifiera un tuyau d'alimentation 20 des shunts 16 en fluide de refroidissement et un tuyau de récupération 22 du fluide ayant traversé les shunts 16.

Le circuit de refroidissement 18 comprend également une pompe 24 permettant d'injecter le fluide de refroidissement dans le tuyau d'alimentation 20 des shunts 16. Selon ce mode de réalisation, le tuyau de de récupération 22 permet de réinjecter le fluide dans la pompe 24. La pompe 24 peut comprendre un dispositif permettant de refroidir le fluide ainsi récupéré de sorte à le réinjecter dans le circuit de refroidissement 18.

A titre d'exemple est de manière non limitative, un ventilateur créant un flux d'air dans le tuyau d'alimentation 20, 22 peut servir de pompe 24.

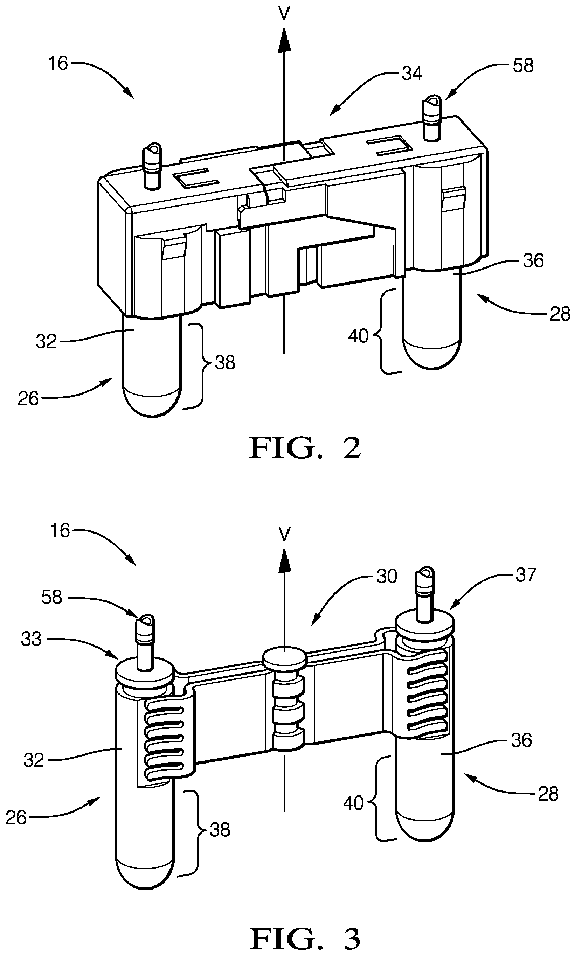

Selon les figures 2 et 3, un mode de réalisation du shunt 16 de connexion électrique prévu pour être refroidi par le circuit de refroidissement 18 est représenté. Le shunt 16 comporte des éléments de conduction électrique telle qu'un premier terminal électrique de connexion 26 et un second terminal électrique de connexion 28 prévus pour être accouplés avec une première et une seconde borne électrique de contact, ainsi qu'un élément électrique de raccordement 30 reliant les deux terminaux électrique de connexion 26, 28.

Chaque terminal électrique de connexion 26, 28 est constitué d'une tige 32, 36 métallique électriquement conductrice logée dans un élément de boitier 34 électriquement isolant. De préférence, chaque tige 32, 36 est globalement de forme cylindrique. L'élément de boitier 34 peut être surmoulé sur les tiges 32, 36 ou les tiges 32, 36 peuvent être emmanchées en force dans l'élément de boîtier 34.

Chaque tige 32, 36 métallique s'étend selon l'axe vertical V. Chaque tige métallique 32, 36 comporte une portion basse permettant l'accouplement de la tige 32, 36 avec une borne électrique de contact. La portion basse de la tige 32, 36 est dénommée ci-après extrémité de contact 38, 40. Dans cet exemple, l'extrémité de contact 38, 40 est une partie mâle globalement cylindrique complémentaire d'une partie femelle se trouvant sur une borne électrique de contact. Autrement dit, selon le mode de réalisation représenté, le premier terminal électrique de connexion 26 et le second terminal électrique de connexion 28 sont des terminaux mâles. Les portions hautes des tiges sont reliées électriquement entre elles par l'élément électrique de raccordement 30.

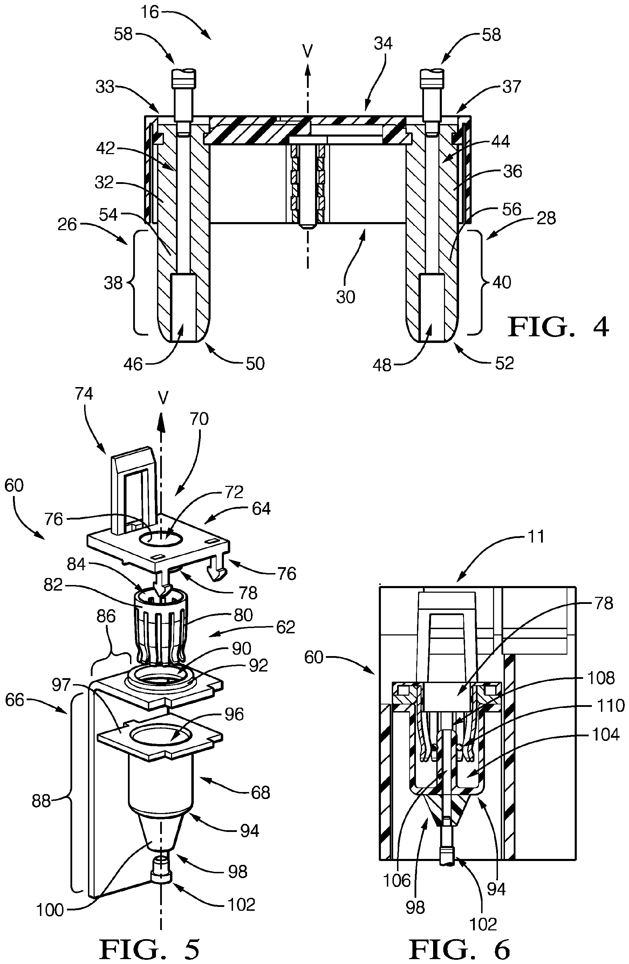

Selon la figure 4, chaque terminal électrique de connexion 26, 28 comporte un conduit débouchant dénommé ci-après conduit de shunt 42, 44 prévu pour faire circuler le fluide de refroidissement au travers de chaque tige 32, 36 métallique. Chaque conduit de shunt 42, 44 s'étend selon l'axe vertical depuis l'extrémité haute 33, 37 de chaque tige 32, 36 métallique jusqu'à une cavité interne 46, 48 de l'extrémité de contact 38, 40, chaque cavité interne 46, 48 débouchant sur l'extrémité libre basse 50, 52 de chaque tige métallique 32, 36. Autrement dit, chaque conduit de shunt 42, 44 s'étend verticalement de manière rectiligne depuis l'extrémité haute 33, 37 de chaque terminal électrique de connexion 26, 28 du shunt 16 jusqu'à la cavité interne 46, 48 de chaque extrémité de contact 38, 40, lesdites cavités internes 46, 48 étant en continuité de fluide avec les conduits de shunt 42, 44. Chaque conduit de shunt 42, 44 comprend donc une extrémité dite extrémité de jonction 54, 56 avec la cavité 46, 48. Chaque conduit de shunt 42, 44 est un conduit débouchant, c'est-à-dire un conduit comprenant une ouverture à chacune de ses extrémités.

L'extrémité haute 33, 37 de chaque tige 32, 36 comprend donc une ouverture permettant d'introduire le fluide de refroidissement dans chaque conduit de shunt 42, 44.

Chaque cavité interne 46, 48 est prévue pour recevoir un pion de guidage et de maintien du shunt 16 dans une borne électrique de contact. De préférence, le conduit 42 de shunt 16 comprend un diamètre d'ouverture constant plus petit que le diamètre d'ouverture de la cavité interne 46.

De manière à simplifier la fixation d'une extrémité du tuyau d'alimentation 20 des shunts 16, un moyen d'interconnexion de shunt 58 entre le conduit de shunt 42 et le tuyau d'alimentation 20 est agencé sur l'extrémité haute 33 de chaque terminal électrique de connexion 26, 28 du shunt 16. De préférence, le moyen d'interconnexion 58 de shunt 16 peut être un moyen de fixation de tuyau de type collier, inséré par vissage dans le conduit de shunt 42. Bien entendu, à des fins d'accessibilité, chaque moyen d'interconnexion de shunt 58 est agencé au travers d'une ouverture de l'élément de boitier 34 électriquement isolant recouvrant l'extrémité haute 33 des terminaux électriques de connexion 26, 28.

De manière alternative, le conduit de shunt 42 peut également être agencé à travers l'élément électrique de raccordement 30 reliant les deux terminaux électriques de connexion 26, 28.

Chaque terminal électrique de connexion 26, 28 peut également ne pas comprendre de cavité interne 46, 48 agencée à l'extrémité de contact 38, 40 dudit terminal 26, 28. Dans cette autre mode de réalisation, chaque conduit de shunt 42, 44 agencé dans chaque terminal électrique de connexion 26, 28 s'étend alors depuis l'extrémité haute 33, 37 de chaque tige 32, 36 jusqu'à l'extrémité basse 50, 52 de chaque tige 32, 36. Selon ce mode de réalisation particulier, il est envisageable d'agencer à l'extrémité basse du conduit 42 de shunt un moyen d'interconnexion de shunt 58, de préférence identique à celui agencé sur chaque extrémité haute 33, 37 du shunt 16, de sorte à pouvoir aisément y fixer le tuyau de récupération 22 du fluide ayant traversé le shunt 16. Dans ce cas de figure, les terminaux électriques de connexion 26, 28 du shunt 16 sont donc prévus pour être insérés dans une borne électrique ne comprenant pas de pion de guidage et de maintien du shunt 16 dans la borne électrique de contact.

Il est à noter que l'utilisation des moyens d'interconnexion 58 pour fixer les tuyaux 20, 22 du fluide de refroidissement permet de faciliter cette interconnexion. Il est envisageable de ne pas agencer ces moyens d'interconnexions 58 sur le shunt 16, de sorte que, par exemple, l'extrémité de chaque tuyau de refroidissement 20, 22 est insérée en force dans chaque conduit de shunt 42, 44.

De manière plus économique, il peut être envisageable de ne pas connecter de tuyaux de refroidissement 20, 22 aux conduits de shunt 42, 44. Une convection naturelle d'air au travers des conduits de shunt 42, 44 pourrait, dans certains cas, suffire au refroidissement du shunt 16.

L'agencement de conduits de shunt 42, 44 ne se limite pas aux shunts comprenant des terminaux électriques de connexion 26, 28 de type mâle. En effet, il est également envisageable d'agencer des conduits de shunt 42, 44 aux travers de terminaux électriques de connexion de type femelle. L'important est d'agencer les conduits de shunt 42, 44 au travers d'au moins un élément de conduction du shunt 16 parcouru par un courant électrique pouvant causer l'échauffement du shunt 16.

Selon la figure 5, un mode de réalisation d'une borne électrique 60 de contact prévue pour recevoir un terminal électrique de connexion du shunt 16 de connexion électrique est représenté. La borne électrique 60 de contact représentée est une borne électrique comprenant un terminal électrique femelle dénommé ci-après terminal électrique de raccord 62. La borne électrique 60 de contact est également prévue pour permettre l'évacuation du fluide de refroidissement pouvant circuler à travers le shunt 16.

La borne électrique 60 de contact comprend, du haut vers le bas, un élément d'accroche 64, de préférence en plastique, prévu pour fixer la borne 60 à un élément de batterie 11, le terminal électrique de raccord 62, une barre omnibus 66 conductrice électriquement prévue pour conduire le courant électrique d'un élément de batterie 11 jusqu'au terminal électrique de raccord 62 et un boîtier plastique 68 prévu pour recouvrir le terminal électrique de raccord 62.

Plus précisément l'élément d'accroche 64 comporte une première plaque 70 plane horizontale comprenant une ouverture centrale 72 prévue pour l'insertion d'un terminal électrique de connexion 26 du shunt 16 dans le terminal électrique de raccord 62. La première plaque 70 permet l'isolation électrique du dessus de la borne. La première plaque 70 est équipée sur une de ses bordures d'une languette 74 creuse s'étendant selon l'axe vertical V vers le haut et permet l'accrochage de la borne électrique 60 de contact sur un ergot. La première plaque 70 est également équipée d'ergots 76 agencés sur une bordure de la première plaque 70 et s'étendant selon l'axe vertical V vers le bas de sorte à pouvoir fixer la première plaque 70 avec le boîtier plastique 68.

L'ouverture centrale 72 de la première plaque 70 est de diamètre sensiblement identique au diamètre de chaque tige 32, 36 des terminaux électriques mâles de connexion 26, 28 du shunt 16. L'ouverture centrale 72 comporte une paroi annulaire 76 s'étendant selon l'axe vertical V depuis la face supérieure de la première plaque 70 jusqu'à son extrémité libre basse agencée au-delà de la face inférieure de la première plaque 70 formant ainsi un anneau 78 sous la première plaque 70.

Le terminal électrique de raccord 62 ou terminal femelle est un terminal de type tulipe comprenant une pluralité de doigt 80 élastique de contact s'étendant selon l'axe vertical V vers le bas depuis une base annulaire 82 jusqu'à leur extrémité libre basse formant un manchon 84 de contact femelle. La base annulaire 82 est prévue pour être assemblée autour de l'anneau 78 de la première plaque 70 de l'élément d'accroche 64. Chaque doigt 80 de contact est courbé axialement vers l'intérieur du terminal électrique de raccord 62 de sorte que le diamètre interne du manchon 84 du terminal électrique de raccord 62 est plus petit que le diamètre de l'ouverture centrale 72 de la première plaque 70 afin que les doigts 80 de contacts puissent venir en contact électrique avec l'extrémité de contact 38 d'une tige 32 du shunt 16 lorsque celui-ci est inséré dans la borne électrique de contact 60.

La barre omnibus 66 comprend une première portion 86 prévue pour être fixé sur le terminal électrique de raccord 62 et une seconde portion 88 prévue pour être fixé sur un pôle positif ou un pôle négatif d'un élément de batterie 11.

La première portion 86 est une seconde plaque horizontale plane comprenant une ouverture circulaire 90. L'ouverture circulaire 90 comporte une paroi circulaire s'étendant selon l'axe vertical V vers le haut depuis la face supérieure de la première portion 86 jusqu'à son extrémité libre haute agencée au-delà de la face supérieure de la première portion 86 formant ainsi une bague 92 sur la première portion 86. La bague 92 est prévue pour être insérée autour et au contact de la base annulaire 82 du terminal électrique de raccord 62 de sorte à conduire le courant électrique d'un élément de batterie 11 vers le terminal électrique de raccord 62 et donc vers la tige 32 du shunt 16 lorsque celle-ci est insérée dans la borne électrique de contact 60. Autrement dit, le diamètre de la bague 92 est légèrement supérieur au diamètre de la base 82 du terminal de raccord 62, de sorte que la bague 92 est prévue pour être insérée en frottement autour de la base 82 du terminal électrique de raccord 62.

La seconde portion 88, en continuité avec la première portion 86, est une plaque verticale plane s'étendant selon l'axe vertical V vers le bas depuis une bordure de la seconde plaque horizontale jusqu'à son extrémité libre basse.

Le boîtier 68 plastique est un boîtier cylindrique comprenant un fond de boîtier 94 et une ouverture supérieure 96 de dimension surfacique identique au fond de boîtier 94. L'ouverture supérieure 96 est une ouverture circulaire comprenant un rebord plan 97 prévu pour venir en appui contre la face inférieure de la première portion 86 de la barre omnibus 66. L'ouverture supérieure 96 du boîtier 68 est de diamètre équivalent au diamètre de la bague 92 de la première portion 86 de la barre omnibus 66.

Le fond de boîtier 94 est pourvu d'une ouverture débouchant sur une cheminée 98 orientée selon l'axe vertical V vers le bas de sorte à permettre l'évacuation du fluide de refroidissement traversant la borne électrique de contact 60. La cheminée 98 s'étend donc depuis le fond de boîtier 94 jusqu'à son extrémité basse 100. La cheminée 98 comprend donc un conduit de cheminée guidant permettant de guider le fluide de refroidissement vers son extrémité basse 100

De manière à simplifier la fixation d'une extrémité du tuyau de récupération 22 à l'extrémité basse 100 de la cheminée 98 de la borne électrique de contact 60, un moyen d'interconnexion de borne 102 est agencé sur l'extrémité basse 100 de la cheminée 98. De préférence, le moyen d'interconnexion de borne 102 peut être un moyen de fixation de tuyau de type collier, inséré par vissage dans la cheminée de la borne. De préférence le moyen d'interconnexion de borne 102 est identique au moyen d'interconnexion de shunt 58.

Selon la figure 6, le fond du boîtier 94 plastique comprend un pion 104 creux de guidage et de maintien du shunt 16 dans la borne électrique de contact 60. Le pion 104 s'étend selon l'axe vertical V vers le haut depuis le fond de boîtier 94 jusqu'à son extrémité libre agencée dans le manchon 84 de contact du terminal électrique de raccord 62. Le pion 104 est agencé de manière coaxiale avec la cheminée 98.

Le creux du pion 104 est agencé en continuité de fluide avec le conduit de la cheminée 98 de sorte à former un conduit débouchant distinct du conduit de shunt 42 et dénommé ci-après conduit de borne 106. Le conduit de borne 106 est prévu pour faire circuler le fluide de refroidissement à travers la borne électrique de contact 60 de manière à récupérer le fluide ayant circulé dans le shunt 16 lorsque celui-ci est accouplé à la borne de contact 60. Le conduit de chaque borne 106 s'étend selon l'axe vertical V depuis l'extrémité haute de chaque pion108 jusqu'à l'extrémité basse 100 libre de chaque cheminée 98. Autrement dit, le conduit de borne 106 s'étend verticalement de manière rectiligne depuis l'extrémité haute 108 de chaque pion104 jusqu'au moyen d'interconnexion de borne 102.

L'extrémité haute 108 du pion 104 d'une borne électrique de contact 60 comprend donc une ouverture permettant de récupérer le fluide refroidissement provenant de l'extrémité de jonction 54 d'un conduit de shunt 42 lorsque le pion 104 est inséré dans la cavité interne d'un terminal électrique 26 du shunt 16.

Selon ce mode de réalisation, le pion 104 de la borne électrique de contact 60 est pourvu d'un joint 110 annulaire. Le joint 110 est agencé autour du pion 104 et est prévu pour être comprimé de façon étanche entre la cavité interne 46 du terminal électrique de connexion 26 mâle et le pion 104 de sorte que lorsque le terminal électrique de connexion 26 du shunt 16 est inséré dans la borne électrique de contact 60, le conduit de shunt 42 et le conduit de borne 106 sont protégés contre toute intrusion de poussière et également de sorte que le fluide de refroidissement transite uniquement entre le conduit de shunt 42 et le conduit de borne 106 sans perte de fluide au niveau de l'extrémité de jonction 54 du terminal électrique de connexion 26.

Selon un autre mode de réalisation, la borne électrique de contact 60 peut être une simple bague conductrice prévue pour venir s'insérer autour d'un terminal électrique de connexion 26 de type mâle. La bague conductrice peut comprendre au moins une extension métallique permettant sa fixation sur un pôle positif ou négatif d'un élément de batterie 11. La bague peut également comprendre un conduit de borne 106 pouvant être agencé, par exemple, au travers de l'épaisseur de la bague. Selon ce mode de réalisation, la borne électrique ne comprend ni l'élément d'accroche 64, ni le boîtier plastique 68 et ni la barre omnibus 66 de la borne électrique de contact 60 de la figure 5.

Selon un mode de réalisation alternatif, la borne électrique de contact peut être une borne comportant des terminaux électrique de raccord de type mâle de sorte à pouvoir être accouplé électriquement à des terminaux électrique de connexion femelle d'un shunt. De préférence, chaque terminal électrique de connexion ou de raccord peut comprendre un conduit prévu pour faire circuler un fluide de refroidissement.

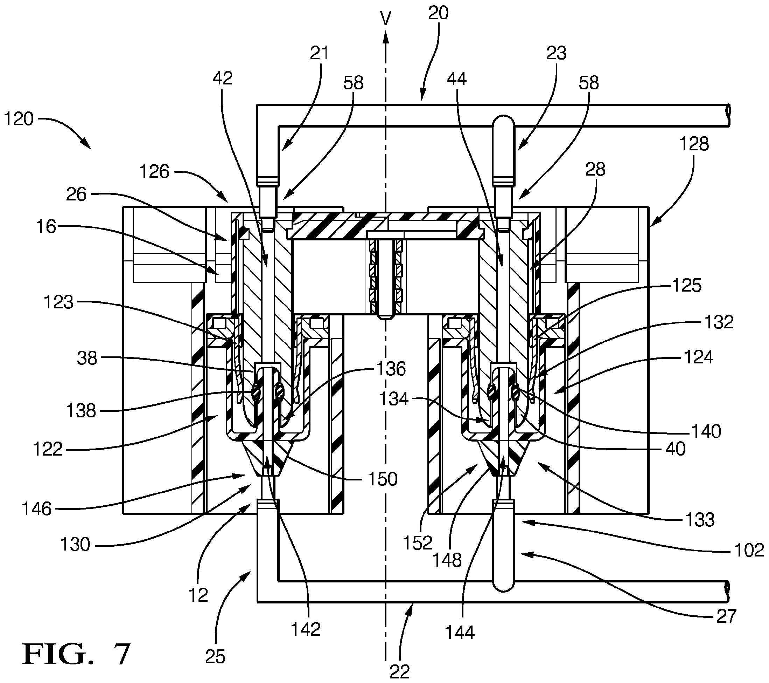

Selon la figure 7, un mode de réalisation d'un assemblage électrique 120 du shunt 16 avec deux bornes électriques de contact 122, 124 est représenté. Le shunt 16 électrique de connexion est inséré dans les bornes électriques de contact 122, 124. Plus particulièrement, le premier terminal électrique de connexion 26 et le second terminal électrique de connexion 28 du shunt 16 sont accouplés électriquement avec une première borne électrique de contact 122 et une seconde borne électrique de contact 124. La première et la seconde borne électrique de contact électrique 122, 124 sont identiques à la borne électrique de contact 60 décrite aux figures 5 et 6. La première borne de contact 122 est fixée à un premier élément de batterie 126, tandis que la seconde borne de contact 124 est fixée à un second élément de batterie 128. Plus particulièrement, la barre omnibus 130 de la première borne électrique de contact 122 est accouplée électriquement à un pôle d'une polarité déterminée du premier élément de batterie 126, par exemple un pôle positif, et la barre omnibus 133 de la seconde borne électrique de contact 124 est accouplée électriquement à un pôle du second élément de batterie 128 d'une polarité complémentaire à celle du pôle du premier élément de batterie 126 accouplée à la barre omnibus 130 de la première borne électrique de contact 122, à savoir par exemple un pôle négatif.

Selon ce mode de réalisation, chaque terminal électrique de connexion 26, 28 est inséré dans un terminal électrique de raccord 130, 132 de sorte que les doigts élastiques de contact 123, 125 de chaque terminal électrique de raccord 130, 132 viennent au contact de l'extrémité de contact 38, 40 de chaque terminal électrique de connexion 26, 28. La cavité interne 46, 48 de chaque extrémité de contact 38, 40 vient s'insérée autour de chaque pion 134, 136 de guidage de chaque borne électrique de contact 122, 124 de sorte que chaque joint annulaire 138, 140 agencé autour de chaque pion 134, 136 est comprimé entre les parois de la cavité interne 46, 48 et chaque pion 134, 136. Cet agencement permet à chaque conduit de borne 142, 144 d'être en continuité de fluide avec chaque conduit de shunt 42, 44, chaque conduit 42, 44, 124, 144 étant rectiligne.

Le conduit de shunt 42, 44 de chaque terminal électrique de connexion 26, 28 du shunt est alimenté en fluide de refroidissement par le tuyau d'alimentation 20 du fluide de refroidissement, le dit tuyau d'alimentation 20 comprenant une première dérivation 21 et une seconde dérivation 23 d'alimentation de sorte à alimenter respectivement le premier et le second terminal électrique de connexion 26, 28. La première et la seconde dérivation du tuyau d'alimentation 21, 23 sont fixées sur chaque conduit de shunt 42, 44 par le moyen d'interconnexion de shunt 58 agencé sur chaque terminal électrique de connexion 26, 28. Le fluide de refroidissement traversant chaque terminal électrique de connexion 26, 28 est récupéré via chaque conduit de borne 142, 144 par le tuyau de récupération 22 du liquide de refroidissement. Plus particulièrement, le tuyau de récupération 22 comporte une première dérivation de récupération 25 et une seconde dérivation de récupération 27 respectivement fixées par le biais du moyen d'interconnexion de borne 102 à l'extrémité basse 150, 152 de chaque cheminée 146, 148, c'est-à-dire à l'extrémité basse de chaque conduit de shunt 142, 144. De préférence, les moyens d'interconnexion de borne 102 sont identiques aux moyens d'interconnexion de shunt 58.

Selon un mode de réalisation particulier, il est envisageable que l'assemblage électrique 120 comprenne un shunt dont un seul terminal électrique de connexion comprend un conduit de shunt, et dont seule la borne électrique de contact accouplée au terminal électrique de connexion comprenant le conduit de shunt comprenne un conduit de borne.

Selon un autre mode de réalisation, il est envisageable que l'assemblage électrique 10 comprenne un shunt dont les terminaux électriques de connexion de type mâle ne comprennent pas de cavité interne et dont les bornes électriques de contact sont de simples bagues conductrices comprenant au moins un moyen conducteur d'accroche avec les pôles des éléments de batterie. Selon cet autre mode de réalisation, il est donc envisageable que les bornes électriques de contact ne comprennent pas de conduits de shunt et qu'au moins un des deux terminaux électrique de connexion de type mâle du shunt comprenne un conduit de shunt s'étendant depuis l'extrémité haute de la tige jusqu'à l'extrémité basse de la tige du terminal électrique de connexion. Les moyens d'interconnexion avec les tuyaux de refroidissement peuvent être agencés sur les deux extrémités de chaque conduit de shunt. Dans cette autre mode de réalisation, il est à noter que la borne électrique de contact ne comprend ni d'élément d'accroche, ni de barre omnibus et ni de boîtier plastique comme illustrés à la figure 5.

L'invention ne se limite pas à l'utilisation du shunt de connexion électrique 16 et de la borne électrique de contact 60 décrits pour raccorder des pôles positifs et négatifs d'éléments de batterie 11 entre eux. Le shunt 16 et la borne 60 selon l'invention peuvent être utilisés dans toute autre application nécessitant l'accouplement électrique de deux éléments pour lesquels un courant électrique doit transiter d'un élément vers l'autre élément.

## Revendications

1. Shunt de connexion électrique (16), prévu pour être couplé électriquement entre deux bornes électriques de contact (122, 124), comportant un ensemble d'éléments de conductions de courant électrique, le dit ensemble d'éléments de conduction comprenant
un premier terminal électrique de connexion (26) et un second terminal électrique de connexion (28), s'étendant selon un axe vertical (V), prévus pour être accouplés avec une première et une seconde borne électrique de contact (122, 124) et prévus pour faire circuler un courant électrique entre chaque borne électrique de contact (122, 124) et le terminal électrique de connexion (26, 28) accouplé à la borne électrique de contact (122, 124) ;
un élément électrique de raccordement (30) des deux terminaux électriques de connexion (26, 28) prévu pour faire circuler le courant électrique d'un terminal électrique de connexion (26) vers l'autre terminal électrique de connexion (28); **caractérisé en ce qu'**au moins un des éléments de conduction (26) comporte un conduit de shunt (42) agencé au travers de l'élément de conduction (26) de sorte à y faire circuler un fluide de refroidissement **caractérisé en ce que** le conduit de shunt (42) est un conduit débouchant dont au moins une extrémité comprend un moyen d'interconnexion de shunt (58) prévu pour y raccorder un tuyau d'alimentation (20) du shunt (16) en fluide de refroidissement, et **en ce que** le conduit de shunt (42) est un conduit rectiligne.

2. Shunt (16) selon l'une quelconque des revendications précédentes **caractérisé en ce que** le premier terminal électrique de connexion (26) est un terminal électrique mâle de connexion comprenant une extrémité de contact (38) globalement cylindrique prévue pour être inséré dans la première borne électrique de contact (122).

3. Shunt (16) selon l'une quelconque des revendications précédentes **caractérisé en ce que** le conduit de shunt (42) est agencé au travers du premier terminal électrique de connexion (26) et s'étend selon l'axe vertical (V).
